# EUROPÄISCHE PATENTSCHRIFT

(11) **EP 0 314 883 B1**
(45) Veröffentlichungstag und Bekanntmachung des Hinweises auf die Patenterteilung: **28.04.1993**
(21) Anmeldenummer: 88112600.7
(22) Anmeldetag: 03.08.1988
(51) Int. Cl.: H03H 7/38, H01P 1/26

(54) **Abschlussimpedanz für Hochfrequenz-Leitungen bzw. -Schaltkreise**
Terminal impedance for high-frequency lines or circuits
Impédance terminale pour ligne ou circuits à hautes fréquences

(30) Priorität: 31.10.1987 DE 3737014
(43) Veröffentlichungstag der Anmeldung: 10.05.1989
(73) Patentinhaber: ANT Nachrichtentechnik GmbH, D-71522 Backnang (DE)
(72) Erfinder: Ashoka, Halappa, Dr.-Ing., D-7150 Backnang (DE); Khilla, Abdel-Messiah, Dr.-Ing., D-7155 Oppenweiler (DE)

(56) Entgegenhaltungen:
- DE-A- 2 548 207
- US-A- 2 880 398
- PATENT ABSTRACTS OF JAPAN, Band 11, Nr. 304 (E-545)[2751], 3. Oktober 1987; & JP-A-62 95 002 (NEC CORP.) 01-05-1987

## Beschreibung

Die vorliegende Erfindung betrifft eine Abschlußimpedanz für Hochfrequenz-Leitungen bzw. -Schaltkreise, die aus mindestens einem Widerstand und einem mit diesem verbundenen Leitungsstück besteht.

Eine derartige Abschlußimpedanz ist z.B. aus der DE-A-25 48 207 bekannt. Gemäß diesem Dokument ist die Abschlußimpedanz zum breitbandigen, reflexionsfreien Abschluß von Mikrowellenleitern vorgesehen. In Mikrowellenschaltungen werden häufig Leitungsabschlußwiderstände benötigt, die in einem größeren Frequenzbereich den reflexionsfreien Abschluß einer Leitung benötigen. Speziell in integrierten Mikrowellenschaltungen ist die Herstellung breitbandiger Abschlußimpedanzen schwierig.

Zum breitbandigen reflexionsfreien Abschluß von Wellenleitern werden häufig in Serie zu einem der beiden Leiter des Wellenleiters geschaltete ohmsche Widerstände vom Wert des Wellenwiderstandes in Kombination mit einem daran anschließenden Kurzschluß zum anderen Leiter verwendet. Bei höheren Frequenzen, insbesondere bei Mikrowellen, tritt hierbei das Problem auf, daß zwischen dem Ort des Widerstandes und der Kurzschlußebene aus konstruktiven Gründen eine gewisse elektrische Leitungslänge wirksam ist, durch welche der Abschlußwiderstand eine unerwünschte Blindkomponente erhält. Diese Blindkomponente wird gemäß DE-A-25 48 207 dadurch kompensiert, daß parallel zum ohmschen Widerstand und der Kurzschlußleitung die Serienschaltung eines weiteren ohmschen Widerstandes vom Wert des Wellenwiderstandes der abzuschließenden Leitung und einer leerlaufenden Leitung von gleicher Länge und gleichem Wellenwiderstand wie die Kurzschlußleitung geschaltet ist. Dabei sind die kurzgeschlossene und die leerlaufende Leitung als planare Leitungsstücke realisiert. Das kurzgeschlossene Leitungsstück ist mit einer Masseleitung auf der Rückseite eines die Leitungsstücke tragenden Substrats galvanisch verbunden. Ein leerlaufendes Leitungsstück hat den Nachteil, daß es elektromagnetische Energie abstrahlt, u.u. gerade bei einer hohen Schaltungsdichte auf andere Leitungen überkoppelt. Und die Herstellung von galvanischen Leitungskurzschlüssen ist mit relativ großem Aufwand verbunden.

Der Erfindung liegt nun die Aufgabe zugrunde, eine Abschlußimpedanz der eingangs genannten Art anzugeben, die in einem möglichst breiten Frequenzbereich wirksam ist, ohne dabei parasitäre elektromagnetische Energie abzustrahlen, und die mit möglichst geringem Aufwand herstellbar ist.

Diese Aufgabe wird durch die Merkmale des Anspruchs 1 gelöst.

Zweckmäßige Ausführungen der Erfindung gehen aus den Unteransprüchen hervor.

Die in der erfundenen Abschlußimpedanz eingesetzten Leitungsstücke sind vorteilhafterweise weder im Leerlauf betrieben noch an den Enden galvanisch kurzgeschlossen, so daß die hiermit verbundenen bereits erwähnten Nachteile beim Gegenstand der Erfindung entfallen.

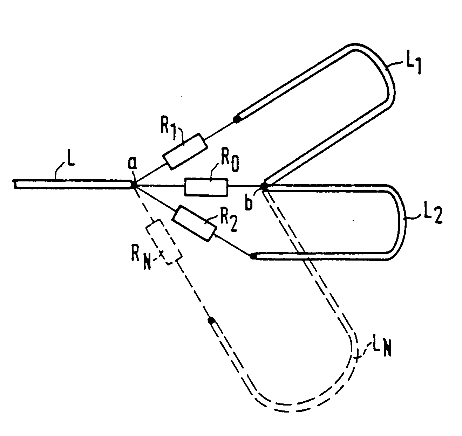

Anhand eines in der Zeichnung dargestellten Ausführungsbeispiels wird nachfolgend die Erfindung näher erläutert.

Die Figur zeigt schematisch eine an den Ausgang a einer Leitung L, die z.B. Teil eines Hochfrequenz-Schaltkreises sein kann, angeschlossene Abschlußimpedanz.

Diese Abschlußimpedanz besitzt einen mit dem Ausgang a der Leitung L verbundenen ersten ohmschen Widerstand R₀. Zu diesem ersten Widerstand R₀ ist mindestens ein Zweig - es können aber auch, wie in der Figur angedeutet, n=1, 2 ... N Zweige sein - parallel geschaltet. Jeder Zweig besteht aus einem ohmschen Widerstand R₁, R₂ bzw. R_{N}, der einerseits am Anschlußpunkt a mit dem ersten Widerstand R₀ verbunden ist und andererseits an ein Ende eines Leitungsstücks L₁, L₂ bzw. L_{N} angeschlossen ist, dessen anderes Ende zum zweiten Anschlußpunkt b des ersten Widerstandes R₀ führt.

Das Leitungsstück L₁, L₂ bzw. L_{N} besitzt eine solche Länge, daß eine darüber geführte Welle eine 180° Phasendrehung erfährt. D.h jedes Leitungsstück L₁, L₂ bzw. L_{N} hat für eine bestimmte Wellenlänge λ eine elektrisch wirksame Länge von z.B. λ/2. Dabei sind alle vorhandenen Leitungsstücke L₁, L₂ ... L_{N} bzgl. ihrer Länge so dimensioniert, daß sie insgesamt für alle in einem vorgegebenen Frequenzband liegenden Wellenlängen 180° phasendrehend wirken.

Der erste Widerstand R₀, die Widerstände R₁, R₂ ... Rₙ in den parallelen Zweigen und die Leitungsstücke L₁, L₂ ... L_{N} sind hinsichtlich ihrer Wellenwiderstände so auszulegen, daß das durch sie gebildete Widerstandsnetzwerk eine Impedanz darstellt, die an die Ausgangsimpedanz der abzuschließenden Leitung L angepaßt ist.

Die vorangehend beschriebene Anordnung ermöglicht es, mit einer entsprechenden Anzahl von parallelen Zweigen und geeigneter Dimensionierung der Widerstände R₀, R₁, R₂ ... R_{N} und der Leitungsstücke L₁, L₂ ... L_{N} eine sehr breitbandige, reflexionsarme Abschlußimpedanz zu realisieren.

Die Leitungsstücke L₁, L₂ ... L_{N} können in Hohlleiter- oder Koaxialleiter-Technik oder als planare Leiter ausgeführt sein.

Bei einem Ausführungsbeispiel der Abschlußimpedanz mit einem zum ersten Widerstand R₀=70,7 Ω parallel geschalteten Zweig, dessen Widerstand R₁=160 Ω beträgt und dessen Leitungsstück L₁ für die Frequenz 12, 7 GHz λ/2 lang ist und einen Wellenwiderstand von 30 Ω besitzt, ist die Rückflußdämpfung im Frequenzband von 7,2 GHz bis 18,2 GHz größer als 20 dB. Ebenfalls größer als 20 dB ist die Rückflußdämpfung für eine Abschlußimpedanz im Frequenzband von 4 GHz bis 28 GHz, wenn zu einem ersten Widerstand R₀=100 Ω zwei Zweige parallel geschaltet sind, von denen der eine einen Widerstand R₁=190 Ω und ein für 8 GHz λ/2 langes Leitungsstück L₁ mit einem Wellenwiderstand von 30 Ω und der andere Zweig einen Widerstand R₂=160 Ω und ein für 16 GHz λ/2 langes Leitungsstück L₂ mit einem Wellenwiderstand von 30 Ω besitzt.

Als besonders vorteilhaft, weil mit geringem Aufwand realisierbar, erweist sich die beschriebene Abschlußimpedanz für den Einsatz in monolithischen Hochfrequenz-Schaltkreisen.

## Patentansprüche

1. Abschlußimpedanz für Hochfrequenz-Leitungen bzw. -Schalkreise, die aus mindestens einem Widerstand und einem mit diesem verbundenen Leitungsstücks besteht, dadurch gekennzeichnet, daß zu einem an den Ausgang (a) einer betreffenden leitung (L) bzw. eines Schaltkreises angeschlossenen ersten Widerstand (R₀) mindestens ein Zweig parallel geschaltet ist, der aus einem weiteren Widerstand (R₁, R₂ ... R_{N}) und einem daran angeschlossenen Leitungsstück (L₁, L₂ ... L_{N}) besteht, daß jeweils das Leitungsstück (L₁, L₂ ... L_{N}) eines jeden zum ersten Widerstand (R₀) parallel geschalteten Zweiges eine solche Länge aufweist, daß sich darüber ausbreitende Wellen bestimmter Wellenlängen eine Phasenumkehr erfahren, und daß der erste Widerstand (R₀), der Widerstand (R₁, R₂ ... R_{N}) eines jeden parallel geschalteten Zweiges und der Wellenwiderstand eines jeden Leitungsstücks (L₁, L₂ ... L_{N}) so dimensioniert sind, daß das durch sie gebildete Widerstandsnetzwerk insgesamt eine an die Ausgangsimpedanz der betreffenden Leitung (L) bzw. des Schaltkreises angepaßte Impedanz aufweist.

2. Abschlußimpedanz nach Anspruch 1, dadurch gekennzeichnet, daß jeweils das Leitungsstück (L₁, L₂ ... L_{N}) eines jeden zum ersten Widerstand (R₀) parallel geschalteten Zweiges eine planare Leitung ist.

3. Abschlußimpedanz nach Anspruch 1, dadurch gekennzeichnet, daß jeweils das Leitungsstück (L₁, L₂ ... L_{N}) eines jeden zum ersten Widerstand (R₀) parallel geschalteten Zweiges ein Hohlleiter ist.

4. Abschlußimpedanz nach Anspruch 1, dadurch gekennzeichnet, daß jeweils das Leitungsstück (L₁, L₂ ... L_{N}) eines jeden zum ersten Widerstand (R₀) parallel geschalteten Zweiges ein Koaxialleiter ist.

## Claims

1. Terminal impedance for high-frequency lines or circuits, which consists of at least one resistor and a terminal clamp connected therewith, characterised thereby that at least one branch is connected in parallel to a first resistor (R₀) connected to the output (a) of a respective line (L) or of a circuit, which branch consists of a further resistor (R₁, R₂...R_{N}) and a terminal clamp (L₁, L₂...L_{N}) connected thereto, that in each case the terminal clamp (L₁, L₂...L_{N}) of each branch connected in parallel to the first resistor (R₀) has such a length that waves, which are of determined wavelengths, propagating thereover undergo a phase reversal, and that the first resistor (R₀), the resistor (R₁, R₂...R_{N}) of each branch connected in parallel and the wave resistance of each terminal clamp (L₁, L₂...L_{N}) are so dimensioned that the resistance network formed by them has in its entirety an impedance matched to the output impedance of the respective line (L) or of the circuit.

2. Terminal impedance according to claim 1, characterised thereby that in each case the terminal clamp L₁, L₂...L_{N}) of each branch connected in parallel to the first resistor (R₀) is a planar conductor.

3. Terminal impedance according to claim 1, characterised thereby that in each case the terminal clamp (L₁, L₂...L_{N}) of each branch connected in parallel to the first resistor (R₀) is a tubular conductor.

4. Terminal impedance according to claim 1, characterised thereby that in each case the terminal clamp (L₁, L₂...L_{N}) of each branch connected in parallel to the first resistor (R₀) is a coaxial conductor.

## Revendications

1. Impédance terminale pour lignes ou circuits à haute fréquence, qui est composée d'au moins une résistance et d'un troncon de ligne relié-à cette résistance, caractérisée en ce qu'elle comprend, montée en parallèle avec une première résistance (R₀) raccordée à la sortie (a) d'une ligne (L) concernée, ou d'un circuit, au moins une branche composée d'une résistance supplémentaire (R₁, R₂ ... R_{N}) et d'un tronçon de ligne (L₁, L₂ ... L_{N}) raccordé à cette résistance, que le tronçon de ligne (L₁, L₂ ... L_{N}) de chaque branche montée en parallèle avec la première résistance (R₀), possède une longueur telle que les ondes se propageant par ce tronçon de ligne et ayant des longeurs d'onde déterminées, subissent une inversion de phase, et que la première résistance (R₀), la résistance (R₁, R₂ ... R_{N}) de chaque branche montée en parallèle avec la première résistance et l'impédance caractéristique de chaque tronçon de ligne (L₁, L₂ ... L_{N}) sont dimensionnées de manière que, globalement, le réseau de résistances formé par eux présente une impédance adaptée à l'impédance de sortie de la ligne (L) concernée ou du circuit.

2. Impédance terminale selon la revendication 1, caractérisée en ce que le tronçon de ligne (L₁, L₂ ... L_{N}) de chaque branche montée en parallèle avec la première résistance (R₀) est une ligne planaire.

3. Impédance terminale selon la revendication 1, caractérisée en ce que le tronçon de ligne (L₁, L₂ ... L_{N}) de chaque branche montée en parallèle avec la première résistance (R₀) est un guide d'ondes.

4. Impédance terminale selon la revendication 1, caractérisée en ce que le tronçon de ligne (L₁, L₂ ... L_{N}) de chaque branche montée en parallèle avec la première résistance (R₀) est un conducteur coaxial.
